# EUROPEAN PATENT APPLICATION

(11) **EP 2 239 787 A1**
(43) Date of publication of application: **13.10.2010**
(21) Application number: 08871176.7
(22) Date of filing: 12.11.2008
(51) Int. Cl.: H01L 31/058, H01L 35/28

(54) **THERMOELECTRIC SOLAR PLATE**

(30) Priority: 25.01.2008 ES 200800194
(71) Applicant: Cerón Parisi, Xavier, 20560 Oñati (Guipúzcoa) (ES); Abal Ciordia, Angel Ma, 20560 Oñati (Guipúzcoa) (ES)
(72) Inventor: Cerón Parisi, Xavier, 20560 Oñati (Guipúzcoa) (ES); Abal Ciordia, Angel Ma, 20560 Oñati (Guipúzcoa) (ES)
(74) Representative: Schäfer, Matthias W.
(86) International application number: PCT/ES2008/000698
(87) International publication number: WO 2009/092827

(57) **Abstract**

Thermoelectric solar panel of the type used to generate electrical power from solar power, **characterised in that** it comprises in its front part a solar power collector panel, in its middle part a plurality of Seebeck-type thermoelectric generator modules, and in its rear part a cooling element, all this being joined together under pressure by means of the appropriate fixing means.

The invention presented herein provides numerous advantages over equivalent devices that are currently available, the most important of them being that the collector surface or visible face of the panel may be made of practically any architectural material, it being capable of being built directly into the structure of a building, both in roofs and facades.

## Description

This document relates, as its title indicates, to a thermoelectric solar panel of the type used to generate electrical power from solar power, **characterised in that** it comprises in its front part a solar power collector panel, in its middle part a plurality of Seebeck-type thermoelectric generator modules, and in its rear part a cooling element, all this being joined together under pressure by means of the appropriate fixing means.

The effect of the generation of electrical power in a metal thermocouple subjected to a difference of temperature in its junctions, also known as the Seebeck effect, was discovered by Thomas Johann Seebeck in the nineteenth century. The formula characterising this effect is **V = a (Tc** - **Tf), where:**
V = voltage (in volts, V)
**a** = Seebeck coefficient, characteristic of each thermocouple (v/K)
Tc = Temperature of the hot junction (Kelvin, K)
Tf = Temperature of the cold junction (Kelvin, K)

The Seebeck coefficients of the metal thermocouples are very low and produce low voltages that restrict their use as electric generators due to the existence of sizeable thermal shifts in the region of hundreds of degrees. The result is that they have long been used only in cases where there is an abundance of heat energy, such as nuclear batteries in space probes, burners on gas and oil pipelines, exhaust fumes emitted by heavy machinery, etc, or in very specific situations with limited accessibility, such as in outer space or in remote or isolated stations.

In the field of renewable energies, the limited amount of electrical power generated rules out the commercial use of electric generators based on the Seebeck effect, with photovoltaic generators and wind-power generators now widely known and used.

The development of semiconductor materials has enabled the manufacture of compact modules that group together a number of thermocouples on small surfaces, each of them possessing a Seebeck coefficient higher than that of metal thermocouples. These modules are able to reach considerable voltages and electrical output levels even at moderate temperature differences in the region of tens of degrees, such as those obtained on surfaces exposed to solar radiation, thus enabling their use as viable generators.

Seebeck modules suitable for the production of electrical power and based on this effect are also known as thermoelectric generators or thermogenerators, TEGs or thermopiles.

There are currently two types of known device that are most commonly used at a domestic level to produce power from solar radiation:
1. Photovoltaic panels: These are generally formed by silicon cells that are sensitive to sunlight and are capable of producing around 100 watts per square metre. They are widely used, due in the main to their relatively low cost, particularly in locations that are some distance away from the grid and also in buildings provided with a suitable surface that is sufficiently large (houses, public buildings, etc) as they cannot easily be built into the architectural structure. They are also used in so-called "solar gardens", which are industrial power-generating facilities. They present the following problems and drawbacks:
   - The structure of the panels, in which the photosensitive silicon surface must be exposed to the sunlight, makes them fragile and also requires regular maintenance and cleaning.
   - They are difficult to build into architectural structures.
   - The electrical performance of the photovoltaic panel decreases as its temperature increases. As the solar radiation heats the photosensitive surface so the electric current decreases.
   - Competition for silicon with the computer industry raises fears of a shortage in the supply of the material and a subsequent rise in the cost of panels.
   - They only generate electrical power.
2. Solar collectors: These panels are designed to make use of solar radiation to heat liquids, generally domestic hot water (DHW) and, to a lesser extent, water for industrial use. Their use has also become more widespread in the obtention of DHW. Their main drawbacks are as follows:
   - As with photovoltaic panels they are also fragile, require maintenance and cannot easily be built into architectural structures.
   - They do not produce electricity.

Other solutions have been sought. For example, patents ES 542450 "A thermoelectric generator with enhanced power factor", ES 432173 "An electrical generator device perfected along with a thermoelectric convertor and a primary source for said device" and US 581506 "A thermoelectric generator apparatus" describe devices based on the Seebeck effect to generate electricity from heat, although they present the problem, as described above, of requiring a high temperature gradient, which means that they may only be used to obtain electricity from a nuclear regulator.

Other types of embodiments based on the Seebeck effect are also known. For example Utility Model 200501577 "Lighting device with energy recovery" discloses a device for generating electricity from heat generated by an LED lighting device, although it does have the drawback of not being directly applicable to the generation of electricity from solar power.

There are also known embodiments such as the one described in Utility Model 230226 "Cold generating device", which uses the same principle for the opposite effect, obtaining cold from electricity.

In order to address existing problems with regard to the generation of electrical power from solar power, the thermoelectric solar panel that is the object of this invention has been designed and which comprises in its top part a solar power collector panel, in its middle part a plurality of Seebeck-type thermoelectric generator modules, and in its bottom part a cooling element, all this being joined together under pressure by means of the appropriate fixing means, which may be mechanical means, adhesive substances, or a combination of both.

The solar power collector panel may be made of any materials commonly used in architectural finishes, such as metal, cement, concrete, brick, porcelain, ceramics, plastic, which means that it may be built directly into the structure of a building, both in roofs and facades. This solar power collector panel increases its temperature by absorbing solar radiation, transmitting that heat to the Seebeck thermoelectric generator modules that are in direct contact, or by means of thermal conductive material, with the collector panel through its hot face.

In the event that there is more than one module, these are electrically connected to each other in series, in parallel or in the most suitable series/parallel combination for the purpose of obtaining an electrical current of suitable characteristics.

The cold face of the Seebeck thermoelectric generator modules is in direct contact, or by means of thermal conductive material, with the cooling element, which may be formed by a directly exposed heat radiator (with fins or another heat diffusing design) or alternatively by suitable pipes, through which flow a cooling liquid, which makes it possible to use the heat drawn from the thermoelectric panel for other uses, such as domestic hot water.

In order to cause the greenhouse effect and boost the increase in temperature, the collector panel may also be provided with a heat-insulating cover transparent to solar radiation.

The thermoelectric solar panel presented herein provides numerous advantages over equivalent devices that are currently available, the most important of them being that the collector surface or visible face of the panel may be made of practically any architectural material, it being capable of being built directly into the structure of a building, both in roofs and facades

Another important advantage provided by the invention is that the collector surface is made of a resistant material that cannot easily be altered and requires little maintenance or cleaning.

Another advantage is that the electrical performance of the thermoelectric panel is a direct linear function of the difference in temperature between the collector surface and the diffuser, with the result that the higher the irradiation and temperature gradient the greater the electrical current obtained.

Another advantage that should also be pointed out is that the production capacity of the thermoelectric module industry greatly exceeds demand, with the result that it is unlikely that the cost of the modules will rise due to supply shortages, not to mention the added advantage that the rest of the components in the thermoelectric panel are standard elements.

We should also point out the undeniable advantage that the option of using liquid to cool the diffuser represents, as this enables hot water to be obtained as a second product, with the combined production of electricity and hot water thereby being achieved in a single panel.

To provide a better understanding of the object of the present invention, a preferred practical embodiment of said thermoelectric solar panel is shown in the drawings attached.

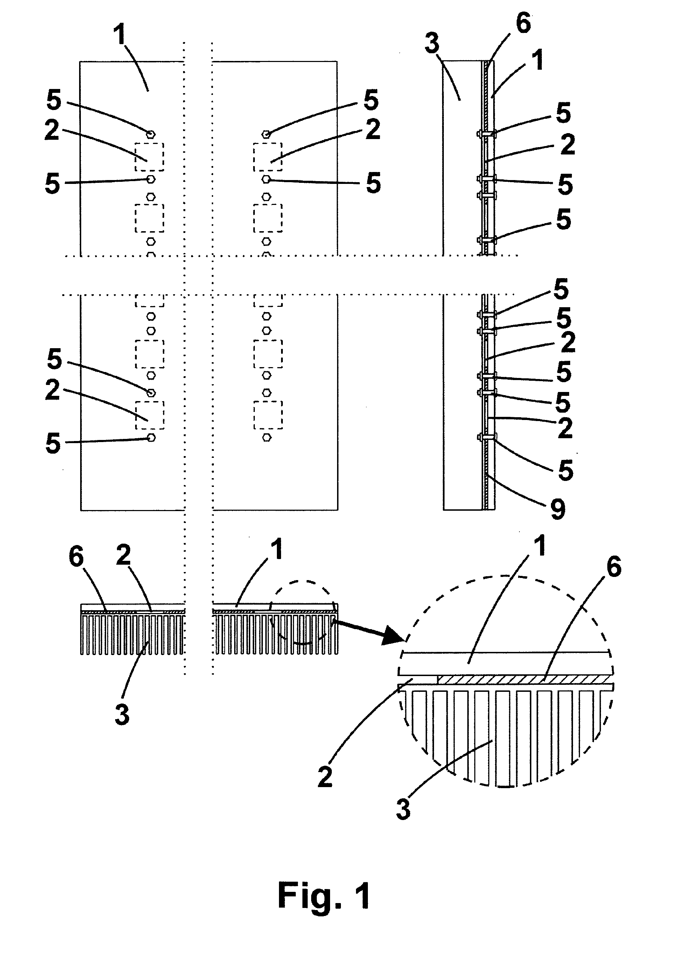

In said drawings Figure 1 shows elevated, ground and profile views, with an enlarged detail, of an example of a thermoelectric solar panel with an exposed collector panel and cooling element of the exposed radiator type.

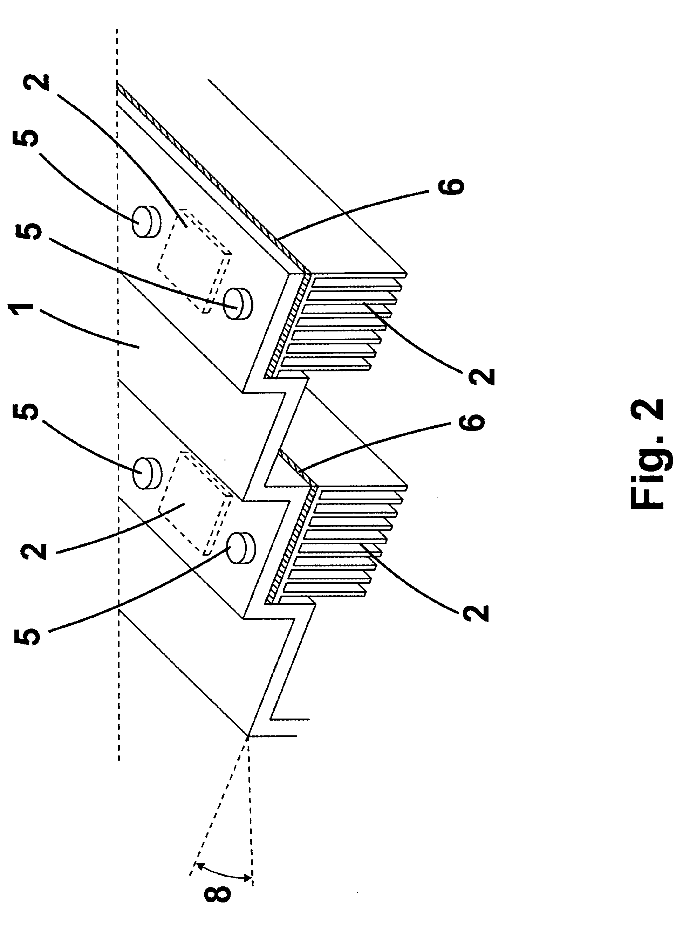

Figure 2 shows an example of the thermoelectric solar panel adapted according to orientation and latitude by means of an angle calculated in accordance with the orientation of the panel and/or latitude.

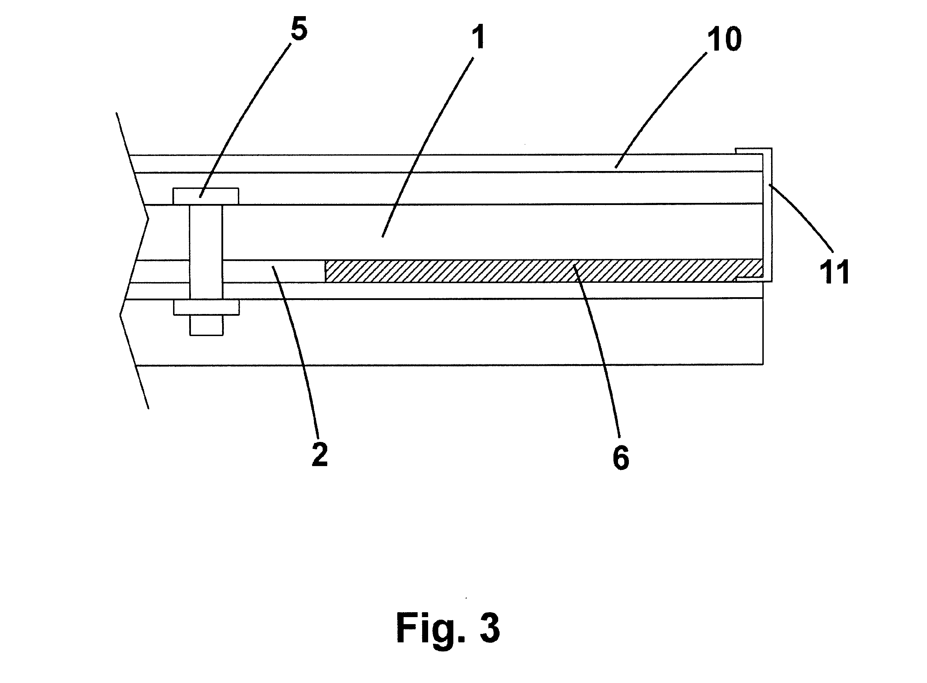

Figure 3 shows an example of an alternative embodiment of the thermoelectric solar panel with collector panel provided with a cover for the greenhouse effect.

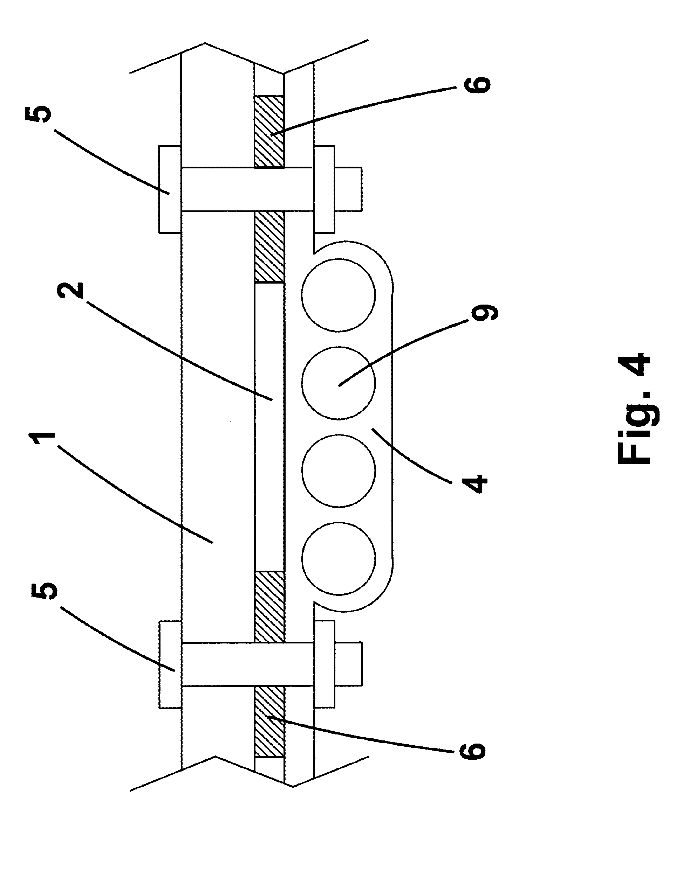

Figure 4 shows an example of an alternative embodiment of the thermoelectric solar panel with cooling element achieved by means of flowing liquid.

The thermoelectric solar panel that is the object of this invention is essentially formed, as may be seen in the drawings attached, by a solar power collector panel (1), in its middle part by one or more Seebeck-type thermoelectric generators (2), and in its rear part by a cooling element (3,4), all this being joined together under pressure by means of the appropriate fixing means (5).

The cooling element is formed by a radiator (3) or alternatively by pipes (4) through which a cooling liquid (9) flows.

The space between the collector panel (1) and the cooling element (3,4) that is not occupied by the Seebeck-type thermoelectric generators (2) is filled with heat-insulating material (6).

The solar power collector panel (1) may be made of any materials commonly used in architectural finishes, such as metal, cement, concrete, brick, porcelain, ceramics, plastic, which means that it may be built directly into the structure of a building, both in roofs and facades. It may be flat or it may adopt a shape inclined or staggered at a suitable angle (8) calculated in accordance with the orientation of the panel and/or latitude in order to obtain the maximum incidence of the rays of sunlight.

This solar power collector panel (1) increases its temperature through the absorption of solar radiation, that heat being transmitted to the Seebeck-type thermoelectric generators (2) that are in direct contact, or by means of an intermediate thermal conductive material, with the collector panel (1) through its hot face.

In the event that there is more than one thermoelectric generator (2), these are electrically connected to each other in series, in parallel or in the most suitable series/parallel combination for the purpose of obtaining an electrical current of suitable characteristics. The electrical current generated is supplied by appropriate connection cables to an external circuit.

The cold face of the Seebeck-type thermoelectric generators (2) is in direct contact, or by means of an intermediate thermal conductive material, with the cooling element preferably formed by a radiator (3) that transfers the heat directly to the air, with fins or another equivalent heat diffusing design.

An alternative embodiment of the invention is provided for, in which the cooling element is formed by pipes (4) through which flows a cooling liquid (9), which enables the use of the heat removed from the thermoelectric panel for other purposes, such as domestic hot water. This alternative embodiment also enables the flow of the cooling liquid (9) to be varied by means of a tap or regulator valve, enabling the obtention of liquid (9) at a temperature that may be regulated in accordance with the position of the tap or regulator valve, given that depending on the amount of flowing liquid (9) a greater or smaller amount of refrigeration is obtained, with the result that it reaches a different temperature.

In order to cause the greenhouse effect and boost the increase in temperature, the collector panel (1) may also be provided with a heat-insulating cover transparent (10) to solar radiation, fixed by means of suitable fastening profiles (11).

The fixing means (5) may be any of the conventionally used mechanical elements, such as screws or heat-insulating clamps or adhesive substances, or a combination of both, provided that they guarantee that the thermal bridge break and the transference of heat between both surfaces is performed solely through the Seebeck modules.

The basic principle behind the thermoelectric solar panel is that when solar radiation falls on the collector panel (1) it causes its temperature to rise. The cooling element (3,4) stays at a lower temperature, however, as excess heat is transferred to the air or the cooling liquid (9). As a result, a difference of temperature is created between the hot and cold faces of the Seebeck-type thermoelectric generators (2), thereby generating the thermoelectric effect. The electrical current produced by the module or combination of modules is transferred to the external circuit for its preparation and use or storage.

## Claims

1. Thermoelectric solar panel of the type used to generate electrical power from solar power, **characterised in that** it comprises in its front part a solar power collector panel (1), in its middle part a plurality of Seebeck-type thermoelectric generators (2), and in its rear part a cooling element (3,4), all this being joined together under pressure by means of the appropriate fixing means (5).

2. Thermoelectric solar panel according to the preceding claim, **characterised in that** the space between the collector panel (1) and diffuser (3,4) that is not occupied by the Seebeck-type thermoelectric generators (2) is filled with heat-insulating material (6).

3. Thermoelectric solar panel according to any of the preceding claims, **characterised in that** the solar power collector panel (1) is a flat surface.

4. Thermoelectric solar panel according to claims 1 to 2, **characterised in that** the solar power collector panel (1) adopts a shape inclined at a suitable angle (8) calculated in accordance with the orientation of the panel and/or latitude.

5. Thermoelectric solar panel according to claims 1 to 2, **characterised in that** the solar power collector panel (1) adopts a shape staggered at a suitable angle (8) calculated in accordance with the orientation of the panel and/or latitude.

6. Thermoelectric solar panel according to any of the preceding claims, **characterised in that** a sheet of intermediate thermal conductive material is inserted between the solar power collector panel (1) and the Seebeck-type thermoelectric generators (2).

7. Thermoelectric solar panel according to any of the preceding claims, **characterised in that** the semiconductor modules (2) are electrically connected to each other in series, in parallel or in the most suitable series/parallel combination for the purpose of obtaining an electrical current of suitable characteristics, which is supplied by appropriate connection cables to an external circuit.

8. Thermoelectric solar panel according to any of the preceding claims, **characterised in that** a sheet of intermediate thermal conductive material is inserted between the cold face of the Seebeck-type thermoelectric generators (2) and the cooling element (3,4).

9. Thermoelectric solar panel according to any of the preceding claims, **characterised in that** the cooling element is formed by a directly exposed heat radiator (3), with fins or another equivalent heat diffusing design.

10. Thermoelectric solar panel according to any of claims 1 to 8, **characterised in that** the cooling element is formed by pipes (4) through which flows a cooling liquid (9).

11. Thermoelectric solar panel according to any of claims 1 to 8 and 10, **characterised in that** the flow of cooling liquid (9) through the pipes (4) may be varied by means of a tap or regulator valve.

12. Thermoelectric solar panel according to any of the preceding claims, **characterised in that** the collector panel (1) is provided with a heat-insulating cover transparent (10) to solar radiation, fixed by means of suitable fastening profiles (11).

13. Thermoelectric solar panel according to any of the preceding claims, **characterised in that** the fixing means (5) are any of the conventionally used mechanical members that guarantee that the thermal bridge break and the transference of heat between both surfaces is performed solely through Seebeck modules.

14. Thermoelectric solar panel according to any of claims 1 to 12, **characterised in that** the fixing means (5) are adhesive substances that guarantee that the thermal bridge break and the transference of heat between both surfaces is performed solely through Seebeck modules.

15. Thermoelectric solar panel according to any of claims 1 to 12, **characterised in that** the fixing means (5) are a combination of conventional mechanical elements and adhesive substances that guarantee that the thermal bridge break and the transference of heat between both surfaces is performed solely through Seebeck modules.

16. Use of a thermoelectric solar panel according to any of the preceding claims, as a built-in part, and using the same materials, of the structure of a building, both in roofs and facades.

17. Use of a thermoelectric solar panel according to any of claims 1 to 8, 10, 11, 13, 14 and 15 for the obtention of hot water for heating.

18. Use of a thermoelectric solar panel according to any of claims 1 to 8, 10, 11, 13, 14 and 15 for the obtention of domestic hot water of a variable temperature.
